# EUROPÄISCHE PATENTSCHRIFT

(11) **EP 1 760 781 B1**
(45) Veröffentlichungstag und Bekanntmachung des Hinweises auf die Patenterteilung: **15.10.2008**
(21) Anmeldenummer: 06017868.8
(22) Anmeldetag: 28.08.2006
(51) Int. Cl.: H01L 23/34, H01L 23/485, H01L 23/66

(54) **Halbleiter-Chip zur Erzeugung einer steuerbaren Frequenz**
Semiconductor chip generating a controllable frequency
Puce semi-conductrice pour la génération d'une fréquence commandable

(30) Priorität: 01.09.2005 DE 102005042706
(43) Veröffentlichungstag der Anmeldung: 07.03.2007
(73) Patentinhaber: ATMEL Germany GmbH, 74072 Heilbronn (DE)
(72) Erfinder: Krimmer, Gerald, 74076 Heilbronn (DE); Reimann, Reinhard, Dr., 74081 Heilbronn (DE)
(74) Vertreter: Müller, Wolf-Christian

(56) Entgegenhaltungen:
- US-A- 5 247 426
- US-A- 5 438 212
- US-A1- 2002 196 085
- US-A1- 2005 023 692
- US-A1- 2006 086 449

## Beschreibung

Die Erfindung betrifft einen Halbleiter-Chip zur Erzeugung einer steuerbaren Frequenz nach dem Oberbegriff des Anspruchs 1.

Halbleiterchips werden auch als "Die" oder "Dice" bezeichnet. Sie werden üblicherweise aus einem Wafer durch einen Vereinzelungsschritt gewonnen. Zur Herstellung des fertigen integrierten Schaltkreises werden elektrisch leitfähige Kontakte des Halbleiterchips in einem so genannten Bond-Vorgang mit zugehörigen Kontakten eines Gehäuses oder Substrats verbunden. Nachfolgend kann sich ein Packungsvorgang anschließen.

Wenn ein derartiger Halbleiterchip in seinem fertig gestellten Zustand zur Erzeugung einer steuerbaren Frequenz dient, beispielsweise als ein so genannter Sendeempfänger oder Transceiver, ist üblicherweise ein spannungsgesteuerter Oszillator (VCO) vorgesehen, der in einem bestimmten ersten Chipbereich des Halbleiter-Chips angeordnet bzw. realisiert ist.

Zur Realisierung der Transceiver-Funktion sind jedoch noch weitere Schaltungsteile notwendig, beispielsweise ein Leistungsverstärker und/oder eine Phasenregelschleife (PLL), die üblicherweise in einem Chipbereich des Halbleiter-Chips angeordnet sind, der dem ersten Chipbereich benachbart ist, da zwischen den Schaltungsteilen enge funktionale Kopplungen bestehen.

Der VCO ist üblicherweise empfindlich gegenüber Temperaturschwankungen, d.h. die von ihm ausgegebene Frequenz hängt von seiner Temperatur ab. Da die PLL bzw. der Leistungsverstärker im Betrieb eine beachtliche Wärmeleistung erzeugt, kann es aufgrund einer thermischen Kopplung zwischen den unterschiedlichen Chipbereichen zu einer störenden Beeinflussung des VCO-Betriebs kommen. Diese Beeinflussung ist insbesondere dann störend, wenn bei Verwendung von Zeitschlitzverfahren der VCO zusammen mit den Wärmequellen jeweils nur kurzzeitig in Betrieb genommen wird und somit ein ständiger Wechsel von Aufheizen und Abkühlen stattfindet.

Zur Verringerung dieser thermischen Effekte kann ein Abstand zwischen der oder den Wärmequellen und dem VCO bzw. dem wärmeempfindlichen Schaltungsteil möglichst groß gewählt werden. Da jedoch die Chipflächen ständig kleiner werden und hohe Betriebsfrequenzen geringe Abstände zwischen den gekoppelten Schaltungsteilen bedingen, sind die dadurch erzielbaren Entkopplungseffekte häufig unbefriedigend.

US-A-5,247,426 schlägt vor Gebiete hoher Leistungsdichte auf einem Chip mit Regionen hoher thermischer Leitung und Gebiete niederer Leistungsdichte nut Regionen niederer thermischer Leitung zu verbinden und so ein erwünschtes Temperatur profil über den Chip zu errichten.

Es ist daher die Aufgabe, einen Halbleiter-Chip zur Erzeugung einer steuerbaren Frequenz der eingangs genannten Art zur Verfügung zu stellen, bei dem die störende thermische Kopplung zwischen dem Chip-bereich mit einer Wärmequelle und dem Chipbereich des spannungsgesteuerten Oszillators möglichst gering ist.

Die Erfindung löst diese Aufgabe durch einen Halbleiter-Chip nach Anspruch 1.

Erfindungsgemäß ist mindestens ein Teil der Kontakte zwischen dem ersten und dem zweiten Chipbereich derart angeordnet, dass er als vollständige oder wenigstens teilweise thermische Abschirmung zwischen dem ersten und dem zweiten Chipbereich fungiert. Die Kontakte bilden eine thermische Senke, in die von der Wärmequelle erzeugte Wärme abfließen kann und somit nicht bzw. lediglich in geringem Ausmaß in den Chipbereich des spannungsgesteuerten Oszillators eintritt. Eine störende Beeinflussung der wärmeerzeugenden Schaltungsteile kann somit wirksam reduziert bzw. verhindert werden.

In einer Weiterbildung dient der mindestens eine Teil der Kontakte zum elektrischen Kontaktieren des spannungsgesteuerten Oszillators. Dies ermöglicht ein einfaches Layout des Chips und eine einfache Zuordnung zu Kontakten des Substrats bzw. des Gehäuses.

In einer Weiterbildung weist der Halbleiter-Chip in einer Draufsicht die Form eines Rechtecks auf und der erste Chipbereich ist im Bereich einer Ecke des Rechtecks angeordnet. Eine derartige Anordnung ermöglicht eine möglichst gute Entkopplung von der oder den Wärmequellen, da die Randlage des ersten Chipbereichs einen durch die Wärmequelle bedingten Wärmeeintrag minimiert.

In einer Weiterbildung liegt die Frequenz in einem Bereich von 5GHz bis 7GHz. Bevorzugt liegt die Frequenz bei 5,8GHz.

In einer Weiterbildung bildet der Halbleiter-Chip einen ISM-Transceiver. Das ISM-Band (Industrial, Scientific and Medical Band) ist ein Frequenzbereich für Kommunikationsgeräte in Industrie, Wissenschaft und Medizin. Eine Lage der ISM-Bänder ist weltweit nicht einheitlich geregelt. So gibt es beispielsweise ISM-Bänder im Frequenzbereich von 902MHz-928MHz, 2.400MHz-2.483,5MHz und 5.800MHz, wobei nur das 2,4-GHz-Band weltweit freigegeben ist.

Vorteilhafte Ausführungsformen der Erfindung sind in den Zeichnungen dargestellt und werden nachfolgend beschrieben. Hierbei zeigen schematisch:
- Fig. 1: eine erste Ausführungsform eines Halbleiter-Chips zur Erzeugung einer steuerbaren Frequenz und
- Fig. 2: eine zweite Ausführungsform eines Halbleiter-Chips zur Erzeugung einer steuerbaren Frequenz.

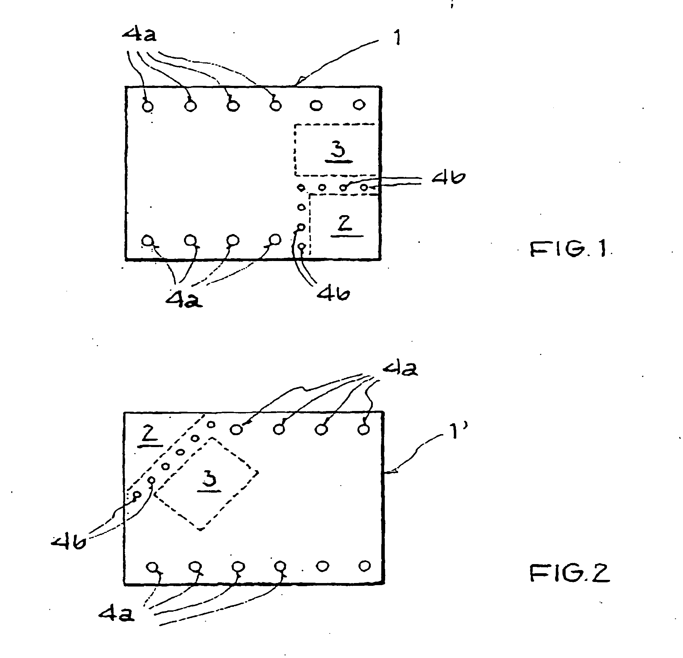

Fig. 1 zeigt eine erste Ausführungsform eines rechteckförmigen Halbleiter-Chips 1 zur Erzeugung einer steuerbaren Frequenz. Nach einem Bondvorgang und einer Verpackung dient er als integrierter Schaltkreis mit ISM-Tranceiver-Funktion.

Der Halbleiter-Chip 1 umfasst einen spannungsgesteuerten Oszillator, der in einem ersten Chipbereich 2 in der rechten unteren Ecke des Halbleiter-Chips 1 angeordnet ist, eine Wärmequelle in Form eines Leistungsverstärkers und einer Phasenregelschleife, die in einem zweiten Chipbereich 3 des Halbleiter-Chips 1 angrenzend zum Chipbereich 2 angeordnet ist, und mehrere metallische Kontakte 4a und 4b zur Kontaktierung des Halbleiter-Chips 1 in einem Bondvorgang. Die Kontakte 4a und 4b sind in Anzahl, Form und Abmessungen lediglich schematisch dargestellt. Der Halbleiter-Chip 1 umfasst selbstverständlich noch weitere, nicht gezeigte Funktionseinheiten bzw. Schaltungsteile.

Die Kontakte 4b, die dem spannungsgesteuerten Oszillator zugeordnet sind, sind zwischen dem ersten und dem zweiten Chipbereich 2 bzw. 3 entlang von zwei rechtwinklig zueinander verlaufenden, sich schneidenden Linien derart angeordnet, dass sich eine thermische Entkopplung zwischen dem ersten und dem zweiten Chipbereich 2 bzw. 3 ergibt. Im zweiten Chipbereich 3 entstehende Wärmeenergie kann über die Kontakte 4b abfließen, ohne eine wesentliche Erwärmung des ersten Chipbereichs 2 zu verursachen. Eine so genannte Frequenzdrift des VCO aufgrund einer Aktivierung bzw. Deaktivierung der Wärmequelle wird somit wirkungsvoll verhindert.

Den Kontakten 4a sind weitere Anschlüsse des integrierten Schaltkreises zugeordnet. Alternativ können selbstverständlich auch diese Kontakte zusätzlich oder ausschließlich zur thermischen Entkopplung verwendet werden. Die Kontakte 4a sind entlang der oberen und der unteren horizontalen Kante des Halbleiter-Chips 1 angeordnet.

Fig. 2 zeigt eine zweite, alternative Ausführungsform eines rechteckförmigen Halbleiter-Chips 1' zur Erzeugung einer steuerbaren Frequenz. Der Halbleiter-Chip 1' entspricht bis auf seine geänderte Topographie dem Halbleiter-Chip 1 von Fig. 1.

Der erste Chipbereich 2 ist in der linken oberen Ecke des Halbleiter-Chips 1' angeordnet und der zweite Chipbereich 3 ist angrenzend zum Chipbereich 2 angeordnet.

Die Kontakte 4b, die dem spannungsgesteuerten Oszillator zugeordnet sind, sind zwischen dem ersten und dem zweiten Chipbereich entlang einer schrägen, in etwa 45° zur Horizontalen geneigten Linie von einer linken vertikalen Kante bis zu einer oberen horizontalen Kante des Halbleiter-Chips 1' angeordnet. Auch bei dieser Kontaktanordnung ergibt sich eine wirkungsvolle thermische Entkopplung der Chipbereiche 2 und 3.

## Patentansprüche

1. Halbleiter-Chip (1, 1') zur Erzeugung einer steuerbaren Frequenz, mit
- einem spannungsgesteuerten Oszillator, der in einem ersten Chipbereich (2) des Halbleiter-Chips (1, 1') angeordnet ist,
- einer Wärmequelle, insbesondere in Form eines Leistungsverstärkers und/oder in Form einer Phasenregelschleife, die in einem zweiten Chipbereich (3) des Halbleiter-Chips (1, 1') angeordnet ist, und
- Kontakten (4a, 4b) zur Kontaktierung des Halbleiter-Chips (1, 1') in einem Bondvorgang,
**dadurch gekennzeichnet, dass**
- mindestens ein Teil der Kontakte (4b) zwischen dem ersten und dem zweiten Chipbereich (2, 3) angeordnet ist, und so als thermische Abschirmung zwischen dem ersten und dem zweiten Chipbereich (2, 3) fungiert.

2. Halbleiter-Chip nach Anspruch 1, **dadurch gekennzeichnet, dass** der mindestens eine Teil der Kontakte (4b) zum elektrischen Kontaktieren des spannungsgesteuerten Oszillators dient.

3. Halbleiter-Chip nach einem der vorhergehenden Ansprüche, **dadurch gekennzeichnet, dass** dieser in einer Draufsicht die Form eines Rechtecks aufweist und der erste Chipbereich (2) im Bereich einer Ecke des Rechtecks angeordnet ist.

4. Halbleiter-Chip nach einem der vorhergehenden Ansprüche, **dadurch gekennzeichnet, dass** die Frequenz in einem Bereich von 5GHz bis 7GHz liegt.

5. Halbleiter-Chip nach einem der vorhergehenden Ansprüche, **dadurch gekennzeichnet, dass** er einen ISM-Transceiver bildet.

## Claims

1. Semiconductor chip (1, 1') for generating a controllable frequency, comprising
- a voltage-controlled oscillator arranged in a first chip region (2) of the semiconductor chip (1, 1'),
- a heat source, particularly in the form of a power amplifier and/or in the form of a phase regulating loop, arranged in a second chip region (3) of the semiconductor chip (1, 1') and
- contacts (4a, 4b) for contact-making with the semiconductor chip (1, 1') in a bonding process,
**characterised in that**
- at least one part of the contacts (4b) is arranged between the first and second chip region (2, 3) and thus functions as a thermal screen between the first and second chip region (2, 3).

2. Semiconductor chip according to claim 1, **characterised in that** the at least one part of the contacts (4b) serves for electrical contact-making with the voltage-controlled oscillator.

3. Semiconductor chip according to any one of the preceding claims, **characterised in that** this has the form of a rectangle in plan view and the first chip region (2) is arranged in the region of a corner of the rectangle.

4. Semiconductor chip according to any one of the preceding claims, **characterised in that** the frequency lies in a range of 5 GHz to 7 GHz.

5. Semiconductor chip according to any one of the preceding claims, **characterised in that** it forms an ISM transceiver.

## Revendications

1. Puce électronique semi-conductrice (1, 1') pour la génération d'une fréquence réglable, comprenant
. un oscillateur asservi en tension, disposé dans une première zone (2) de la puce électronique semi-conductrice (1, 1'),
. une source de chaleur, plus particulièrement sous la forme d'un amplificateur de puissance et/ou d'une boucle régulatrice de phase, disposée dans une deuxième zone (3) de la puce électronique semi-conductrice (1, 1'), et
. des contacts (4a, 4b) pour l'établissement des contacts de la puce électronique semi-conductrice (1, 1') dans un processus de soudage de connexions,
**caractérisée en ce que**
. au moins une partie des contacts (4b) sont disposés entre la première et la deuxième zone de puce électronique (2, 3), et agissent ainsi comme écran thermique entre la première et la deuxième zone de puce électronique (2, 3).

2. Puce électronique semi-conductrice selon la revendication 1, **caractérisée en ce que** cette au moins une partie des contacts (4b) sert à la connexion électrique de l'oscillateur asservi en tension.

3. Puce électronique semi-conductrice selon l'une quelconque des revendications précédentes, **caractérisée en ce que** dans une vue en plan, celle-ci présente la forme d'un rectangle, et **en ce que** la première zone de puce électronique (2) est disposée dans la zone d'un coin du rectangle.

4. Puce électronique semi-conductrice selon l'une quelconque des revendications précédentes,
**caractérisée en ce que** la fréquence se situe sur une plage allant de 5GHz à 7GHz.

5. Puce électronique semi-conductrice selon l'une quelconque des revendications précédentes, **caractérisée en ce qu'**elle constitue un émetteur-récepteur ISM.
